# DEMANDE DE BREVET EUROPEEN

(11) **EP 0 587 482 A1**
(43) Date de publication de la demande: **16.03.1994**
(21) Numéro de dépôt: 93402156.9
(22) Date de dépôt: 03.09.1993
(51) Int. Cl.: G01R 33/24

(54) **Sonde de magnétomètre à RMN à un seul résonateur et à solution radicalaire unique**

(30) Priorité: 07.09.1992 FR 9201634
(71) Demandeur: COMMISSARIAT A L'ENERGIE ATOMIQUE, F-75015 Paris (FR)
(72) Inventeur: Kernevez, Nelly, F-38700 Corenc (FR); Glenat, Henri, F-38700 Corenc (FR)
(74) Mandataire: Signore, Robert

(57) **Abrégé**

Un flacon 10 contient une solution radicalaire unique 30. Un seul résonateur est accordé sur une des fréquences de résonance électronique de la solution.

Application à la mesure des champs magnétiques.

## Description

### Domaine de l'invention

La présente invention a pour objet une sonde de magnétomètre à RMN (Résonance Magnétique Nucléaire) à un seul résonateur et à solution radicalaire unique. Elle trouve une application dans la mesure précise des champs magnétiques, notamment du champ magnétique terrestre.

La sonde de l'invention est d'un type connu, décrit par exemple dans les demandes de brevet français FR-A-1 447 226 et FR-A-2 098 624. Le principe de fonctionnement de ces sondes peut être rappelé brièvement.

Lorsqu'un échantillon liquide, dont les noyaux atomiques ont un moment magnétique et un moment cinétique non nuls, est soumis à un champ magnétique, les moments magnétiques nucléaires ont tendance à s'aligner parallèlement ou antiparallèlement au champ. La différence d'énergie entre ces deux états définit une énergie de résonance nucléaire ou une fréquence de résonance nucléaire, laquelle tombe généralement dans la gamme des basses fréquences, de l'ordre du millier de Hertz.

Cependant, avec les champs habituels, la polarisation nucléaire globale (positive ou négative) présentée par l'échantillon reste faible et difficilement détectable.

L'effet OVERHAUSER-ABRAGAM permet d'augmenter sensiblement cette polarisation. A cette fin, on dissout une substance paramagnétique appropriée dans un solvant, cette substance étant choisie pour posséder un électron non apparié donnant naissance à un niveau électronique excité présentant une structure hyperfine à quatre sous-niveaux. En général, la fréquence de pompage permettant de porter la substance sur l'un de ces sous-niveaux électroniques est située dans la gamme des hautes fréquences, de l'ordre de quelques dizaines de MégaHertz.

Le couplage dipolaire entre le spin électronique de la substance paramagnétique ainsi excitée et le spin nucléaire du solvant augmente considérablement la polarisation de ce dernier. Selon la transition électronique excitée, on favorise la polarisation nucléaire positive ou la polarisation nucléaire négative du solvant.

Cette technique est encore perfectionnée par la mise en oeuvre d'un "double effet". Une première solution radicalaire (c'est-à-dire un solvant avec une substance paramagnétique) est soumise à une haute fréquence qui sature le niveau électronique favorisant la polarisation positive du solvant, alors qu'une deuxième solution radicalaire est soumise à une haute fréquence qui sature le niveau électronique favorisant la polarisation négative du solvant.

Dans le premier cas, un signal d'excitation à la fréquence de résonance nucléaire appliqué à l'échantillon sera absorbé par celui-ci alors que, dans le second cas, un signal d'excitation à cette même fréquence provoquera une émission stimulée à la fréquence de résonance. Des enroulements de prélèvement montés en série-opposition et disposés autour de la première et de la seconde solutions délivreront alors des tensions de même fréquence mais de phases opposées. Un branchement sur un amplificateur différentiel permettra d'en faire la somme. Tous les signaux parasites induits dans ces enroulements, et qui, eux, ont la même phase, seront annulés.

Une telle sonde à double effet peut fonctionner avec deux solutions différentes et une seule fréquence d'excitation, à condition que les spectres d'absorption des deux solutions soient décalés l'un par rapport à l'autre de telle sorte que la fréquence unique corresponde à la polarisation positive pour l'un et à la polarisation négative pour l'autre.

Mais une sonde à double effet peut fonctionner aussi avec une même solution répartie en deux échantillons et en appliquant à ces deux échantillons deux fréquences différentes, pour saturer séparément les deux sous-niveaux de la substance paramagnétique.

Enfin, par un dernier perfectionnement, le signal délivré par la sonde, qui est à la fréquence de résonance nucléaire, peut être réinjecté comme signal d'excitation des échantillons, dans un montage en boucle qui fonctionne alors en oscillateur. On obtient alors une sonde du type "oscillateur à couplage de spins".

La sonde de l'invention appartient à ce type.

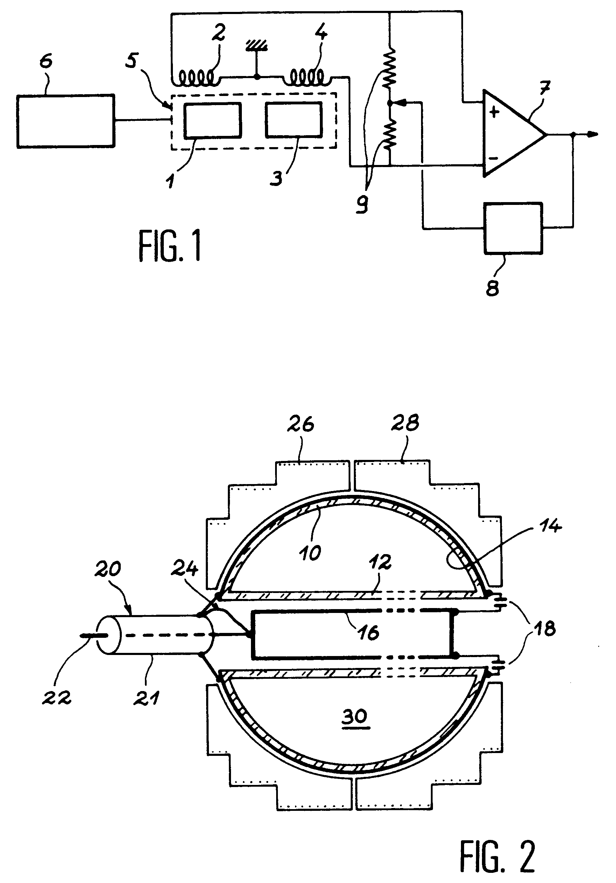

Sur la figure 1 annexée, on voit ainsi une sonde comprenant un premier flacon 1 à polarisation positive avec son enroulement basse fréquence 2, un second flacon 3 à polarisation négative avec son enroulement basse fréquence 4, un résonateur unique haute fréquence 5 entourant les deux flacons et un générateur haute fréquence 6 alimentant ce résonateur. Les deux enroulements 2 et 4 sont montés en série-opposition et sont reliés aux entrées positive et négative d'un amplificateur différentiel 7, dont la sortie est rebouclée, par l'intermédiaire d'un régulateur de niveau référencé 8, sur les enroulements basse fréquence, le bouclage s'effectuant à travers un pont résistif d'équilibrage 9.

La fréquence du signal délivré par un tel oscillateur est égale à la fréquence de résonance nucléaire, laquelle est directement proportionnelle au champ magnétique ambiant, le facteur de proportionnalité étant égal au rapport gyromagnétique des noyaux atomiques.

De nombreux modes de réalisation de ces sondes ont été décrits dans les deux documents déjà cités ainsi que dans FR-A-2 583 887 et FR-A-2 610 760.

### Exposé de l'invention

Bien que donnant satisfaction à certains égards, ces sondes présentent l'inconvénient d'être complexes en raison de la duplication des moyens mis en oeuvre : double résonateur et/ou double solution radicalaire.

La présente invention a justement pour but de remédier à cet inconvénient. A cette fin, elle préconise l'utilisation d'une sonde ne comprenant qu'un seul résonateur et une seule solution radicalaire présentant l'effet OVERHAUSER-ABRAGAM. A priori, pour l'homme du métier, une telle sonde ne devrait pas fonctionner car, en raison de la symétrie d'une sonde à un résonateur et une solution, les tensions induites dans les deux enroulements reliés à l'amplificateur différentiel devraient s'annuler complétement de sorte qu'aucun signal ne devrait être disponible à la sortie de l'amplificateur. En effet, comme expliqué plus haut, dans un résonateur ayant un axe de révolution avec, le long de cet axe, deux flacons contenant deux échantillons différents, le phénomène de polarisation dynamique s'établit de manière homogène le long de l'axe. Seul le signal de polarisation change avec les solutions employées. Pour l'une il sera positif et pour l'autre il sera négatif. Les deux flacons vont donc créer des tensions induites de sens opposés dans les deux enroulements qui les entourent et l'amplificateur différentiel qui en fait la différence délivrera un signal double.

Or, cette interprétation, qui a toujours été celle de l'homme du métier, n'est probablement qu'approximative car, comme l'a remarqué le Demandeur, elle n'est pas parfaitement en accord avec l'expérience. L'interprétation qui concorde le mieux avec l'expérience consiste à supposer que le phénomène de polarisation ne s'établit pas de manière homogène dans la solution. Elle semble s'établir de manière privilégiée aux extrémités du flacon. Le Demandeur ne peut, pour l'instant, expliquer théoriquement ce phénomène inattendu, mais le fait est là : la polarisation dynamique n'est pas homogène en volume et elle est plus intense à une extrémité du flacon qu'à l'autre. En conséquence, dans une sonde à un seul flacon contenant une seule solution radicalaire, le signal global délivré par l'amplificateur différentiel ne sera pas nul, contrairement à toute attente, et cela en raison de cette dissymétrie. C'est ce qu'a pu vérifier le Demandeur.

La solution radicalaire utilisée présente au moins une résonance électronique. Elle peut en présenter une ou deux à deux fréquences, ou plus de deux.

La sonde de l'invention est donc particulièrement simple, avec son unique flacon et son unique solution radicalaire. Cette unicité de l'échantillon confère à la sonde une meilleure tenue en présence d'un gradient de champ magnétique, par rapport aux sondes à deux échantillons.

La sonde de l'invention est également simplifiée par l'utilisation d'un seul résonateur. La tenue en température s'en trouve améliorée et la consommation diminuée.

En définitive, la sonde de l'invention est donc d'un coût plus faible. De plus, elle ne nécessite qu'un seul générateur haute-fréquence.

Mais cette simplicité présente un revers.

La sonde de l'invention a une sensibilité faible, une amplitude de signal réduite, une isotropie assez mauvaise. Par ailleurs, la sonde peut être sensible aux parasites extérieurs en fonction du montage des bobinages. Lorsque les bobinages de la sonde sont assemblés en série-série, l'amplificateur différentiel ne peut alors rejeter les bruits captés et la sonde est sensible aux parasites extérieurs. Un blindage permettrait de limiter la sensibilité aux parasites.

Lorsque les bobinages sont montés en série-opposition comme dans les sondes de l'art antérieur, la sonde est dite anti-bruit ; elle est alors insensible aux parasites extérieurs. Mais pour ce type de montage, l'amplitude de signal est nettement inférieure à celle du montage série-série et la sonde comporte un axe interdit : elle ne fonctionne pas quand son axe est colinéaire au champ à mesurer.

Les domaines d'application de l'invention sont donc ceux où l'on recherche des appareils de faible coût, dans un environnement électromagnétique peu perturbé ou bien dans ceux où l'on peut orienter la sonde dans une direction déterminée favorable. Il peut s'agir du milieu marin, des puits pétroliers, etc...

### Brève description des dessins

- la figure 1, déjà décrite, montre une sonde de magnétomètre selon l'art antérieur ;
- la figure 2 montre, en coupe, une sonde selon l'invention ;
- la figure 3 montre un exemple de spectre de signal nucléaire en fonction de la fréquence saturant les niveaux électroniques ;
- les figures 4a, 4b montrent les connexions d'une sonde et de ses amplificateurs dans le cas d'un montage série-série des bobinages (4a) et dans le cas d'un montage série-opposition des bobinages (4b) ;
- la figure 5 montre une courbe d'anisotropie d'amplitude d'une sonde montée en série-série, c'est-à-dire la variation de la tension délivrée par la sonde dans une rotation de l'axe de celle-ci dans un plan où elle passe d'une orientation colinéaire à une orientation perpendiculaire au champ terrestre ;
- la figure 6 montre une autre courbe d'anisotropie d'amplitude d'une sonde, montée en série-série, c'est-à-dire la variation de la tension délivrée dans une rotation de l'axe dans un plan horizontal.

### Exposé détaillé d'un mode de réalisation

La sonde représentée sur la figure 2 comprend un flacon 10, par exemple en pyrex, avec une forme sphérique (mais une forme conique, cylindrique ou autre est possible). Un tube central 12, également en pyrex, est disposé sur l'axe de la sonde. Le flacon sphérique 10 est recouvert extérieurement d'une couche conductrice 14, par exemple une peinture à l'argent recuite à 550°C. Cette couche peut n'être pas continue mais divisée en secteurs (1 à 8 par exemple) pour éviter la formation de courants de FOUCAULT lors du déplacement de la sonde dans le champ à mesurer. Le tube central 12 contient un cylindre conducteur creux 16, par exemple en argent, qui est l'âme centrale du résonateur et qui est raccordée à la surface sphérique conductrice 14 par des condensateurs amagnétiques 18. Ces condensateurs sont réglables pour permettre de régler la fréquence du résonateur coaxial ainsi formé.

Ce résonateur est connecté à un câble coaxial 20, par exemple d'impédance 50 Ohms, formé par un conducteur extérieur 21 et un conducteur central 22. Le conducteur extérieur 21 est relié au conducteur extérieur 14 du résonateur et le conducteur central 22 est relié à l'âme centrale 16. Une boucle 24 permet une adaptation du résonateur à l'impédance du câble (50 Ohms par exemple) en reliant le conducteur extérieur 21 du câble à l'âme centrale 16.

Le résonateur est complétement entouré par deux enroulements 26, 28 qui présentent, intérieurement, une forme de calotte sphérique et, extérieurement, une forme en escaliers (les zones peu actives ayant été supprimées pour éviter un poids excessif). Les deux enroulements 26, 28 sont identiques en forme et placés symétriquement par rapport au plan médian de la sonde et sont connectés en série, soit série-série, soit série-opposition.

Le flacon 10 contient une solution radicalaire unique 30. Cette solution est de tout type connu dans cette application. On peut citer par exemple le TANO 15N deutérié, dissous dans un mélange de diméthoxyéthane (DME) et d'eau ou dans le méthanol ou dans le tétrahydrofurane.

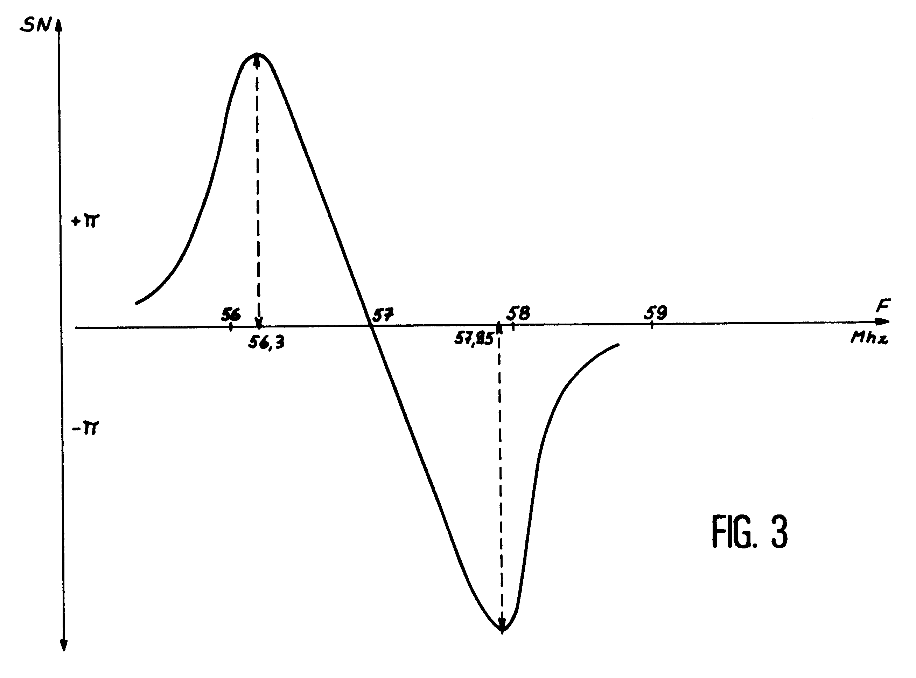

A titre d'exemple, la figure 3 montre le signal nucléaire SN obtenu à partir d'une solution de TANO 15ND dans le tétrahydrofurane en fonction de la fréquence d'excitation électronique F. On voit apparaître deux résonances correspondant aux deux transitions classiques, l'une correspondant à une polarisation positive, l'autre à une polarisation négative, autrement dit l'une à un signal nucléaire de phase positive, l'autre à un signal nucléaire de phase négative. Dans l'exemple considéré, ces deux fréquences se situent respectivement à 56,3 MHz et 57,95 MHz. Selon l'invention, on accorde le résonateur sur l'une de ces deux fréquences.

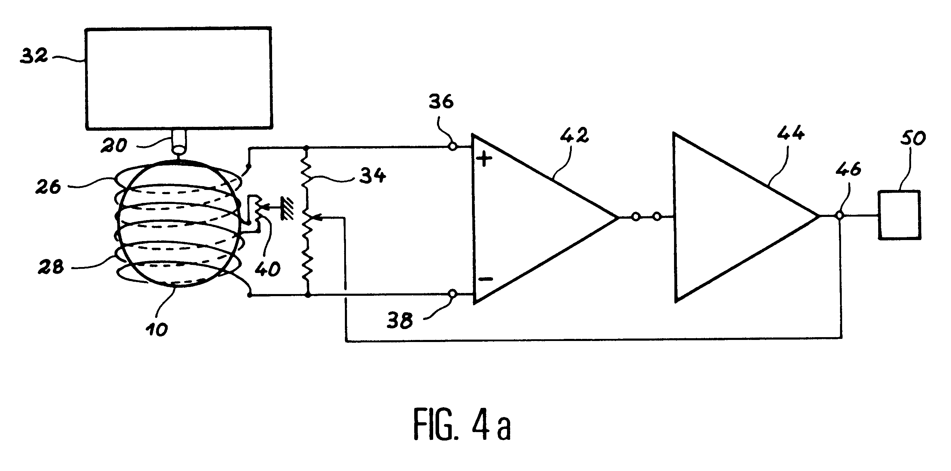

La figure 4a montre les moyens électroniques associés à la sonde qui vient d'être décrite. On y retrouve le flacon sphérique unique 10, formant résonateur avec sa surface conductrice et l'âme centrale, ce résonateur étant relié par le câble coaxial 20 à un générateur haute fréquence 32.

On retrouve encore les deux enroulements symétriques 26, 28 qui servent à la fois à l'excitation et à la détection du signal nucléaire. Ils sont électriquement connectés en série et le montage des bobinages est tel que les enroulements tournent dans le même sens une fois assemblés sur la sonde.

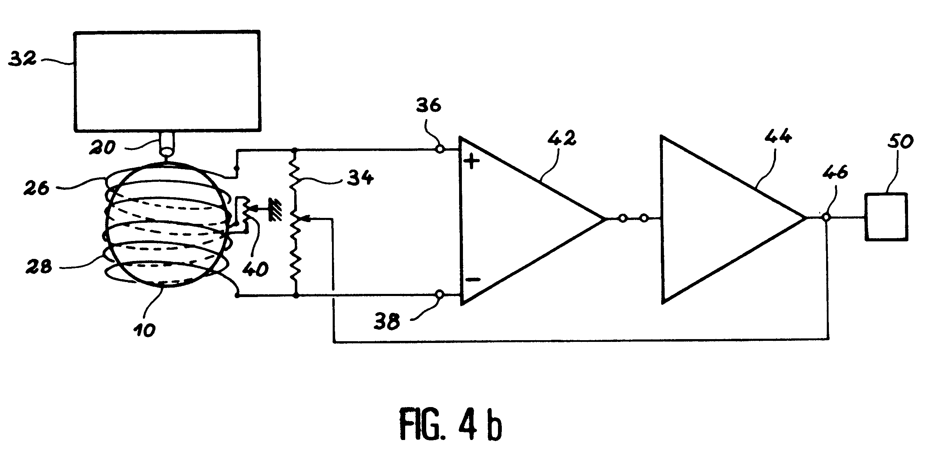

La variante présentée figure 4b correspond à un montage des bobinages en série-opposition ; ils sont électriquement connectés en série mais les enroulements tournent en sens contraire. Tous les autres éléments de la figure 4b sont identiques à ceux de la figure 4a.

Les deux enroulements 26 et 28 sont reliés à un potentiomètre 34 qui permet de régler à la même valeur les amplitudes des tensions apparaissant aux points 36, 38. De façon avantageuse, un second potentiomètre 40 permet d'ajuster les écarts de phase résultant d'écarts de construction des bobinages.

Les deux points 36 et 38 sont reliés aux entrées directe et inverse d'un amplificateur différentiel 42, lequel peut être suivi d'un second amplificateur 44 dont la sortie 46 est rebouclée sur le potentiomètre 34.

Le signal présent à la sortie 46 est le signal dont la fréquence permet de déterminer la valeur du champ magnétique ambiant. Un fréquencemètre 50 en donne la valeur.

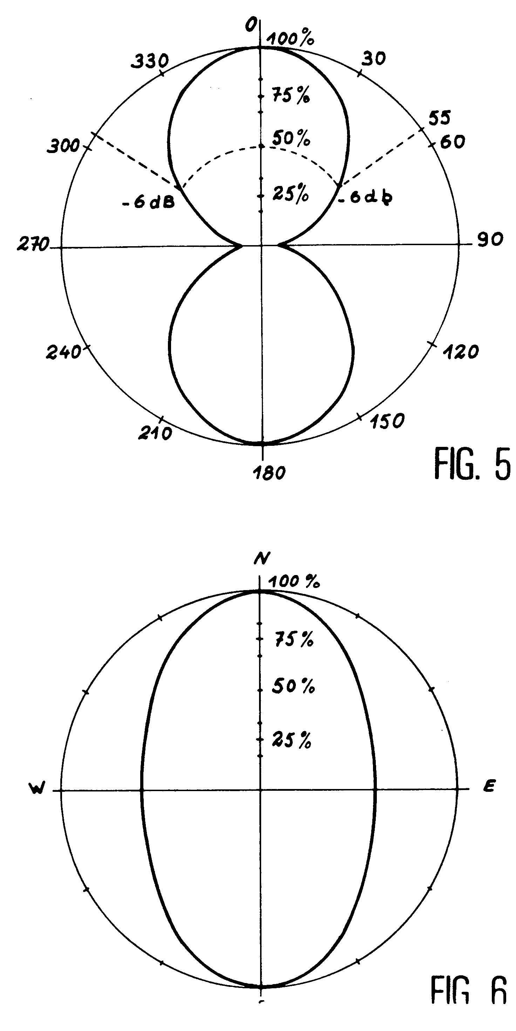

Comme indiqué plus haut, la très grande simplicité de la sonde de l'invention se paye en partie par une certaine anisotropie. La figure 5 montre à cet égard la variation du signal électrique délivré en fonction de l'orientation de la sonde par rapport à un champ magnétique ambiant. Le signal est maximal lorsque la sonde est perpendiculaire au champ (angle 0 et 180 degrés), et minimal lorsqu'elle est parallèle à celui-ci (angle 90 et 270 degrés).

La figure 6 montre la variation du signal délivré par la sonde lors d'une rotation de la direction de la sonde dans le plan horizontal à nos latitudes, c'est-à-dire pour une inclinaison du champ terrestre de 62° par rapport à l'horizontale. La variation d'amplitude entre des orientations Nord-Sud ou Est-Ouest de la sonde est d'environ 40%.

Lorsque la sonde est assemblée en série-opposition, qui est la variante correspondant à la figure 4b, l'anisotropie est encore plus importante. Il y a même non fonctionnement de la sonde quand son axe est parallèle au champ à mesurer.

Cette anisotropie n'est pas rédhibitoire. En effet, il existe de nombreuses applications où la sonde peut être utilisée dans une direction fixe. Compte tenu de la connaissance de son anisotropie, la sonde sera positionnée dans l'orientation qui lui confère le maximum de signal. Les applications visées pour cette sonde sont celles qui nécessitent un faible coût, plus que de grandes performances.

## Revendications

1. Sonde de magnétomètre à résonance magnétique nucléaire, caractérisée par le fait qu'elle comprend :
- un seul flacon (10) contenant une seule solution radicalaire (30), présentant au moins une résonance électronique à une fréquence déterminée,
- un seul résonateur radiofréquence (14, 16) contenant ledit flacon (10), ce résonateur ayant une fréquence de résonance accordée sur la fréquence de résonance électronique,
- un seul générateur radiofréquence (32) relié audit résonateur (14, 16) et excitant celui-ci à la fréquence de résonance électronique,
- un premier et un deuxième enroulements (26, 28) assurant simultanément l'excitation et la détection nucléaire et entourant complétement le flacon (10) et le résonateur (14, 16), ces enroulements étant identiques en forme et disposés face à face, et étant connectés électriquement en série,
- un amplificateur différentiel (42) à deux entrées directe et inversée (36, 38) reliées respectivement aux premier et deuxième enroulements d'excitation et de détection (26, 28).

2. Sonde selon la revendication 1, caractérisée par le fait que le premier et le deuxième enroulements sont connectés en série-série, les enroulements étant de même sens.

3. Sonde selon la revendication 1, caractérisée par le fait que le premier et le deuxième enroulements sont connectés en série-opposition, les enroulements étant de sens contraire.
